# EUROPEAN PATENT APPLICATION

(11) **EP 2 108 968 A1**
(43) Date of publication of application: **14.10.2009**
(21) Application number: 08800781.0
(22) Date of filing: 04.09.2008
(51) Int. Cl.: G01R 31/02

(54) **A METHOD AND A SYSTEM FOR CALIBRATING THE PARAMETERS OF A BUS**

(30) Priority: 07.09.2007 CN 200710145953
(71) Applicant: Huawei Technologies Co., Ltd., Longgang District, Shenzhen Guangdong 518129 (CN)
(72) Inventor: XU, Ruilin, Longgang District 518129 Shenzhen (CN)
(74) Representative: Kreuz, Georg Maria
(86) International application number: PCT/CN2008/072269
(87) International publication number: WO 2009/033409

(57) **Abstract**

The present invention discloses a method and system for correcting bus parameters with a test access device and a method and system for deciding whether test line connections are correct. A test device tests at least one access node bus and when access nodes are networked in cascade mode via test lines, test parameters of an access node in an open circuit and/or a short circuit are obtained; and the measurement results are corrected according to the test parameters. The method for deciding whether test line connections are correct includes: obtaining line A to line B resistance from test parameters obtained when the access node is short-circuited; and deciding whether test line connections are correct according to the line A to line B resistance. With the present invention, wires required in a test may be greatly reduced and the measurement error may be smaller. Because whether test line connections are correct can be decided, correct wire connections may be guaranteed in a test.

## Description

### Field of the Invention

The present invention relates to test technologies, and in particular, to a method and system for correcting bus test parameters with a test access device and a method and system for deciding whether test line connections are correct when access nodes are networked in cascade mode.

### Background of the Invention

A telecommunications network is basically made up of an access layer, a convergence layer and a backbone layer. The access layer provides access for various subscribers, includes twisted-pair access, optical access, and radio access. Because the access layer relates to many devices and subscriber loops, the access layer is the part most liable to failure in the entire network and also the part relatively harder for troubleshooting and maintenance in the network.

Take the widely applied X Digital Subscriber Line (xDSL) for example, such as Asymmetrical Digital Subscriber Loop (ADSL), Asymmetrical Digital Subscriber Loop 2+ (ADSL2+), Super High Speed DSL (SHDSL), Very High Rate DSL (VDSL) and Very High Rate DSL 2 (VDSL2), which are based on twisted pairs. To guarantee the normal operation of xDSL access services, different types of faults must be diagnosed in time and therefore it is necessary to measure line parameters (such as line voltage, line resistance, line capacitance, line background noise, and line to ground balance), terminal devices and network devices (such as the Digital Subscriber Line Access Multiplexer (DSLAM) port, Broadband Remote Access Server (BRAS), and Dynamic Host Configuration Protocol (DHCP) server). Based on the measurement data, the operation status of lines, terminal devices and network devices are known and a failure impacting the service operation can be located quickly and fixed in time.

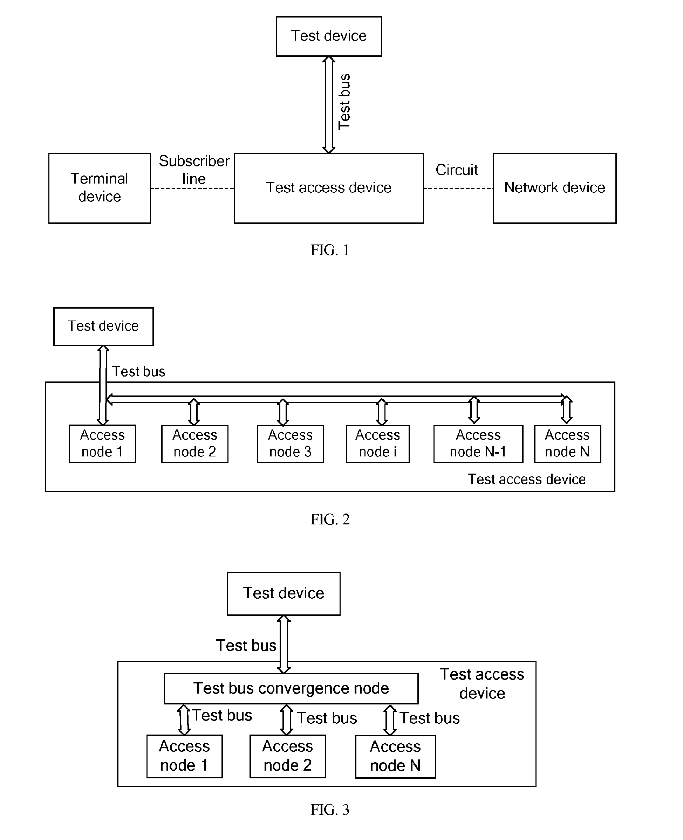

Therefore, the access layer should provide a test bus for test devices. At present, however, most DSLAMs operating in a network do not provide the test bus or the line capture capability (which means connecting a tested subscriber line to a test device automatically according to a control command). In a prior art, to realize automatic tests of the DSLAMs and related subscriber lines, a test access device, such as a Test Access Matrix (TAM) and an Automatic Main Distribution Frame (ADMF), is adopted to help connect an xDSL subscriber to a test device without a test bus. The structure for access by means of a test access device is illustrated in FIG. 1.

FIG. 2 illustrates the working structure of a test access device, where accessed subscribers are distributed at different test access nodes: access node 1, access node 2, ..., access node N. Therefore, there are usually a number of test access nodes in one geographic location. One test bus is led from each test access node and the test buses of all test access nodes are finally connected to the test device. The test device then tests subscriber lines via the test buses.

In a prior art, tests are carried out at a convergence node.

FIG. 3 illustrates a test system structure where tests are carried out at a convergence node. In FIG.3, the test bus of each test access node is routed to a test bus convergence node. Inside the test bus convergence node, multiple test buses converge to one test bus by means of relays. Then subscriber lines are connected to the test device via the one test bus for testing.

The inventor, however, finds that this solution consumes more cabinet space for the addition of one test bus convergence node. Furthermore, because one test bus is led from each test access node to the test bus convergence node, a lot of wires are used so that more space and efforts are required for installation.

### Summary of the Invention

Embodiments of the present invention provide a method and system for correcting bus parameters so as to reduce test errors with bus parameters when access nodes are networked in cascade mode.

To achieve the foregoing objective, an embodiment of the invention uses test parameters obtained when each access node is in an open circuit and/or a short circuit as adjustment parameters; based on the same idea, using the test parameters of a short-circuited access node, an embodiment of the invention provides a method and system for deciding whether test line connections are correct so as to decide whether test line connections of the incoming bus and the outgoing bus of each access node are correct.

A method for correcting bus parameters includes:

obtaining test parameters of an access node in an open and/or short circuit; and

correcting measurement results according to the test parameters.

A system for correcting test bus parameters includes a test device, at least two access nodes, test lines, an obtaining apparatus, and a correcting apparatus, where:

the test device tests at least one access node bus;

the access nodes are networked in cascade mode via the test lines;

the obtaining apparatus is connected to the correcting apparatus and each access node, and adapted to obtain test parameters of the access node in an open circuit and/or a short circuit; and

the correcting apparatus is connected to the obtaining apparatus and the test device, and adapted to correct measurement results of the test device according to the test parameters obtained by the obtaining apparatus.

Because test access nodes are connected to the test device in cascade mode, wires required are greatly reduced. In addition, because circuit parameters in an open circuit and a short circuit are obtained for later correction of measurement results, the measurement error is smaller.

A method for deciding whether test line connections are correct includes:

obtaining line A to line B resistance in measurement data of an access node in a short circuit; and

deciding whether test line connections are correct according to the line A to line B resistance.

A system for deciding whether test line connections are correct includes a test device, at least two access nodes, test lines, an obtaining apparatus, an extracting apparatus, and a deciding apparatus, where:

the test device tests at least one access node bus;

the access nodes are networked in cascade mode via the test lines;

the obtaining apparatus is connected to the extracting apparatus and each access node, and adapted to obtain test parameters of the access node in an open circuit and/or a short circuit;

the extracting apparatus is connected to the deciding apparatus, and adapted to extract line A to line B resistance from the test parameters obtained by the obtaining apparatus; and

the deciding apparatus is adapted to decide whether test line connections are correct according to the line A to line B resistance extracted by the extracting apparatus.

In a test, wires must not be inversed at the incoming bus port and the outgoing bus port of an access node. The method obtains line A to line B resistance from the measurement data of the access node when the node is short circuited, and decides whether test line connections are correct according to the line A to line B resistance so as to guarantee correct wire connections in the test.

### Brief Description of the Drawings

FIG. 1 is a schematic drawing illustrating a structure where access is implemented by means of a test access device in a prior art;

FIG. 2 is a schematic drawing illustrating a working structure of the test access device in the prior art;

FIG. 3 is a schematic drawing of a test system structure where tests are carried out at a convergence node in a prior art;

FIG. 4 is a schematic drawing illustrating a test system structure under a cascade test scheme;

FIG. 5 is a schematic drawing illustrating a procedure of a method for correcting bus parameters in an embodiment of the invention;

FIG. 6 is a schematic drawing illustrating a structure of a system for correcting bus parameters in an embodiment of the invention;

FIG. 7 is a schematic drawing illustrating a specific structure of the system for correcting bus parameters in an embodiment of the invention;

FIG. 8 is a schematic drawing illustrating a procedure of a method for deciding whether test line connections are correct in an embodiment of the invention; and

FIG. 9 is a schematic drawing illustrating a structure of a system for deciding whether test line connections are correct in an embodiment of the invention.

### Detailed Description of the Invention

The embodiments of the present invention are hereinafter described in detail with reference to the accompanying drawings.

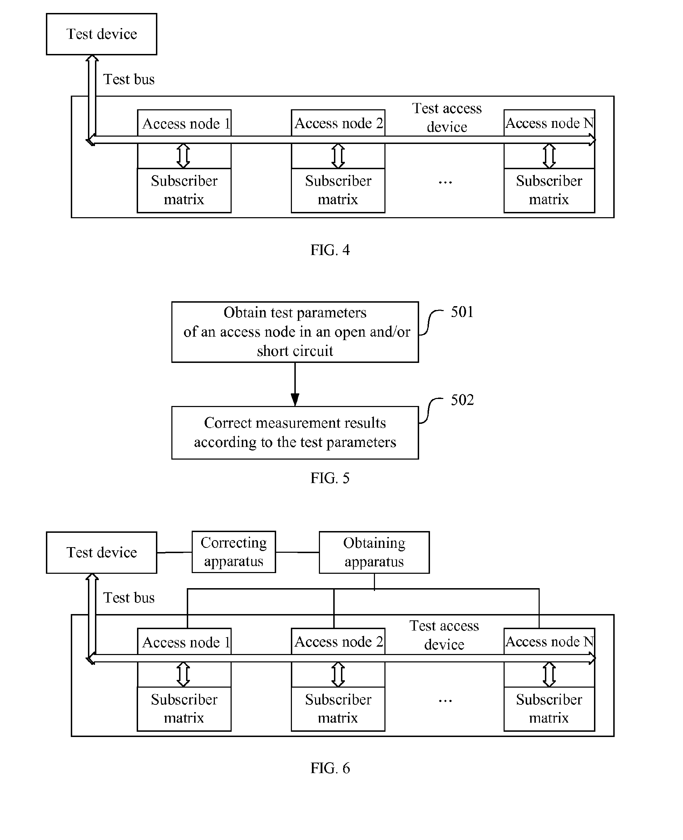

FIG. 4 illustrates a test system structure under a cascade test scheme, where each test access node includes an incoming bus port and an outgoing bus port. The incoming bus port and the outgoing bus port of a node are connected to the test bus of the node. The test bus led from the test device is connected to the incoming bus port of access node 1; the outgoing bus port of access node 1 is connected to the incoming bus port of access node 2 via an electrical wire and so on; the outgoing bus port of access node i-1 is connected to the incoming bus port of access node i; finally, a cascade test bus is formed. In the test environment, corrections may be made according to the following method.

FIG. 5 is a schematic drawing illustrating the procedure of a method for correcting bus parameters according an embodiment of the invention, where a test device tests at least two access node buses. Access nodes are networked in cascade mode via test lines. The procedure includes the following steps:

Step 501: Obtain test parameters of an access node in an open and/or short circuit.

Step 502: Correct measurement results according to the test parameters.

In practice, access nodes are first connected in cascade mode as follows:
connect the test bus of the test device to the incoming bus port of the first access node, connect the outgoing bus port of the first access node to the incoming bus port of the second access node, and connect the outgoing bus port of the second access node to the incoming bus port of the third access node, and so on until all access nodes under test are connected.

An access node is connected to its subscriber matrix via an access bus port.

In the above test environment, step 501 of obtaining test parameters of an access node in an open and/or short circuit is specifically as follows:

Disconnect the incoming bus port, outgoing bus port and access bus port of an access node under test, test the access node by using the test device and use the obtained test result as the test parameters of the access node in an open circuit;

Disconnect the outgoing bus port and access bus port of an access node under test, loop test lines via the incoming bus port, test the access node by using the test device and use the obtained test result as the test parameters of the access node in a short circuit.

In practice, access nodes are connected via test lines, including line A and line B; the test parameters include one or a combination of line A to ground resistance, line B to ground resistance, line A to line B resistance, line A to ground capacitance, line B to ground capacitance, line A to line B capacitance, line attenuation, and line length.

A system for correcting bus parameters is also provided according to an embodiment of the invention. The system is detailed hereunder with reference to the accompanying drawings.

FIG. 6 is a schematic drawing illustrating the structure of the system for correcting bus parameters. The system includes a test device, test lines, an obtaining apparatus, a correcting apparatus and at least two access nodes. The structure is as follows:

The test device tests at least one access node bus. The access nodes are connected in cascade mode via test lines. The obtaining apparatus is connected to the correcting apparatus and each access node. The correcting apparatus is connected to the obtaining apparatus and the test device.

The obtaining apparatus is adapted to obtain test parameters of an access node in an open and/or short circuit.

The correcting apparatus is adapted to correct measurement results of the test device according to the test parameters obtained by the obtaining apparatus.

In practice, when access nodes are connected in cascade mode, the structure is as follows: the test bus of the test device is connected to the incoming bus port of the first access node; the outgoing bus port of the first access node is connected to the incoming bus port of the second access node; and the outgoing bus port of the second access node is connected to the incoming bus port of the third access node, and so on.

An access node is connected to its subscriber matrix via an access bus port.

In practice, the obtaining apparatus may include an open circuit obtaining module, and/or a short circuit obtaining module, and a switching module.

The switching module is connected to access nodes and adapted to control connection and disconnection of the incoming bus port, outgoing bus port, and access bus port of each access node connected with the module.

The open circuit obtaining module is adapted to: control the switching module to break connections of the incoming bus port, outgoing bus port and access bus port of the access node under test, trigger the test device to carry out a test, and obtain the test result as the test parameters of the access node in an open circuit.

The short circuit obtaining module is adapted to: control the switching module to break connections of the outgoing bus port and access bus port of the access node under test, loop test lines via the incoming bus port, trigger the test device to carry out a test, and obtain the test result as the test parameters of the access node in a short circuit.

Another embodiment of the system for correcting bus parameters is described below.

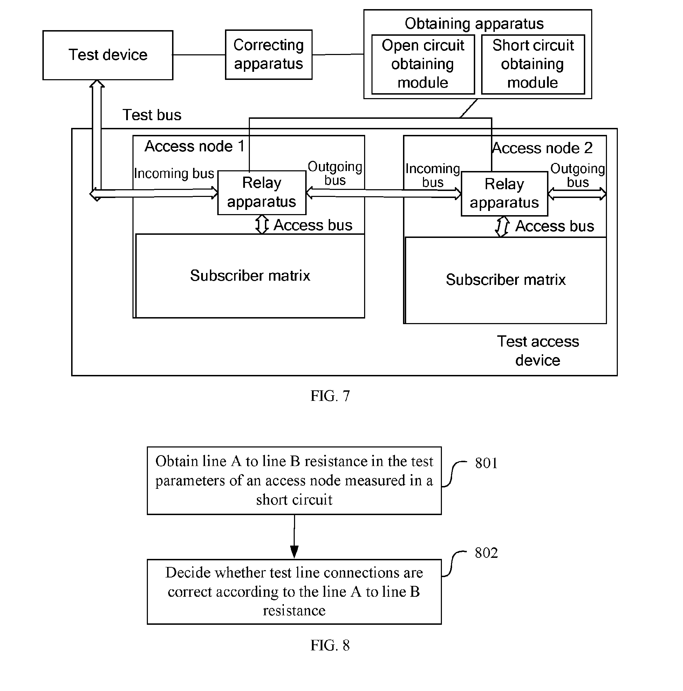

FIG. 7 is a schematic drawing illustrating the structure of the system for correcting bus parameters. The system includes a test device, a test bus, and a test access device, where the test device includes at least two access nodes, access node 1 and access node 2. In this embodiment, two access nodes are described for the purpose of illustration, but it is easy to know that the embodiment may be extended to a system environment with a number of access nodes.

In particular, the switching module is a relay apparatus and connected to the access nodes, adapted to control connection and disconnection of the incoming bus port, outgoing bus port and access bus port of each access node connected with the module. In the embodiment, a relay apparatus is added to the internal test bus of each test access node to implement functions of the switching module. The structure is as follows:

The test bus of the test device is connected to the incoming bus port of access node 1; the outgoing bus port of access node 1 is connected to the incoming bus port of access node 2; and the outgoing bus port of access node 2 is connected to incoming bus port of the next access node and so on.

Access node 1 and access node 2 are connected to respective subscriber matrixes via respective access bus ports.

The relay apparatus is connected respectively to the incoming bus port, outgoing bus port and access bus port of the access node where the relay apparatus is located.

The relay apparatus is adapted to implement the following functions:

Make the incoming bus and outgoing bus always connected and make the access bus disconnected in normal situations;

Control a specified access node to converge subscriber lines to the test bus according to a command sent by the test device, when the incoming bus and access bus of the specified access node are connected and its outgoing bus is disconnected;

Control a specified access node to disconnect its incoming bus, outgoing bus and access bus according to a command sent by the test device;

Control a specified access node to loop its incoming bus, and disconnect its outgoing bus and access bus according to a command sent by the test device.

In this embodiment, a relay apparatus is described for the purpose of illustration but the switching module is not limited to the relay apparatus. Any apparatus that is able to set up and break connections between multiple ports can be adopted as a switching module.

In the foregoing test environment, the automatic correction of the test bus between the access nodes and the test device may be practiced as follows:

A1. The test device delivers a command to control a specified access node to disconnect its incoming bus, outgoing bus and access bus;

A2. The test device tests the test bus to obtain circuit parameters of the test bus in the case of an open circuit, such as line A to ground resistance, line B to ground resistance, line A to line B resistance, line A to ground capacitance, line B to ground capacitance, line A to line B capacitance, line attenuation, and line length;

B1. The test device delivers a command to control a specified access node to loop its incoming bus and disconnect the incoming bus from the outgoing bus and access bus;

B2. The test device tests the test bus to obtain circuit parameters of the test bus in the case of a short circuit, such as line A to ground resistance, line B to ground resistance, line A to line B resistance, line A to ground capacitance, line B to ground capacitance, line A to line B capacitance, line attenuation, and line length;

C. The test device stores the circuit parameters of the test bus in the case of an open circuit and a short circuit in an internal storage device of the test device and corrects measurement results according to the circuit parameters after the test device tests a subscriber line, where the correction is made in a regular approach, for example, a capacitance is corrected by deducting the capacitance in the circuit parameters of the test bus in an open circuit from the capacitance measurement result.

Because wires cannot be connected inversely at the incoming bus port and outgoing bus port in a test, a method for checking whether wires inversed at the incoming bus port and outgoing bus port is provided according to an embodiment of the invention. The embodiment is described in detail with reference to the accompanying drawing.

FIG. 8 is a schematic drawing illustrating the procedure of a method for deciding whether test line connections are correct, applicable to a system where a test device tests at least one access node bus and the access nodes are connected in cascade mode via test lines. The procedure includes the following steps:

Step 801: Obtain the line A to line B resistance in the test parameters of the access node in a short circuit;

Step 802: Decide whether connections of the test lines are correct according to the line A to line B resistance.

In practice, the access nodes are first connected in cascade mode as follows: the test bus of the test device is connected to the incoming bus port of the first access node; the outgoing bus port of the first access node is connected to the incoming bus port of the second access node; and the outgoing bus port of the second access node is connected to the incoming bus port of the third access node, and so on.

An access node is connected to its subscriber matrix via an access bus port.

In the above test environment, step 801 of obtaining test parameters of the access node in a short circuit is specifically as follows:
disconnecting the outgoing bus port and access bus port of the access node under test and loop test lines via the incoming bus port;
testing the access node by using the test device and use the obtained test result as the test parameters of the access node when the node is short-circuited; and
obtaining the line A to line B resistance from the test parameters.

In practice, the correctness of test line connections may be decided according to whether the resistance between line A and line B is within a self-mixing range.

When the resistance between line A and line B is within the self-mixing range, the test line connections are correct; when the resistance between line A and line B is beyond the self-mixing range, the test line connections are incorrect.

The self-mixing range may indicate that the resistance between line A and line B is below 2,000 ohm.

A system for deciding whether test line connections are correct is also provided according to an embodiment of the invention. The system is detailed hereunder with reference to the accompanying drawing.

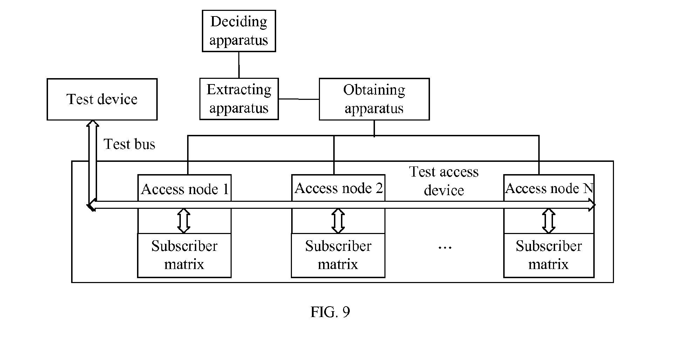

FIG. 9 is a schematic drawing illustrating the system for deciding whether test line connections are correct. The system includes a test device, at least one access node, test lines, an obtaining apparatus, an extracting apparatus and a deciding apparatus. The structure is as follows:

The test device tests at least one access node bus and access nodes are connected in cascade mode via test lines. The obtaining apparatus is connected to the extracting apparatus and each access node; the extracting apparatus is connected to the deciding apparatus and the obtaining apparatus. The working process is as follows:

The obtaining apparatus obtains test parameters of the access node when the node is short-circuited; the extracting apparatus extracts the line A to line B resistance from the test parameters obtained by the obtaining apparatus; the deciding apparatus decides whether test line connections are correct according to the line A to line B resistance extracted by the extracting apparatus.

In practice, when access nodes are connected in cascade mode, the structure is as follows: the test bus of the test device is connected to the incoming bus port of the first access node; the outgoing bus port of the first access node is connected to the incoming bus port of the second access node; and the outgoing bus port of the second access node is connected to the incoming bus port of the third access node, and so on.

An access node is connected to its subscriber matrix via an access bus port.

The obtaining apparatus may include a short circuit obtaining module and a switching module.

The switching module is connected to access nodes and adapted to control connection and disconnection of the incoming bus port, outgoing bus port, and access bus port of each access node connected with the module.

The short circuit obtaining module is adapted to control the switching module to break connections of the outgoing bus port and access bus port of the access node under test, loop test lines via the incoming bus port, trigger the test device to carry out a test, and obtain the test result as the test parameters of the access node in a short circuit.

The deciding apparatus may include a first deciding module and a second deciding module.

The first deciding module is adapted to decide that test line connections are correct when the line A to line B resistance is within the self-mixing range.

The second deciding module is adapted to decide that test line connections are incorrect when the line A to line B resistance is beyond the self-mixing range.

This means, to check whether wires are inversed at the incoming bus port and the outgoing bus port, the specified test access node is controlled to loop the incoming bus according to a command delivered by the test device and disconnect the access bus and the outgoing bus; the test device tests the test bus to obtain the line A to line B resistance; the test device checks whether the line A to line B resistance is within the self-mixing range (below 2,000 ohm); if the line A to line B resistance is within the self-mixing range (below 2,000 ohm), the wire connections are correct or else incorrect.

The embodiments of the invention provide a solution for automatically obtaining bus parameters of a test bus in an open circuit and a short circuit for later correction of measurement results and a solution for automatically checking whether the wires at the incoming bus port and the outgoing bus port of a test access node are inversed. Because test access nodes are connected to the test device in cascade mode, fewer wires are required for testing. Because the test parameters in an open circuit and a short circuit is provided for correction, and the circuit parameters of the test bus in an open circuit and a short circuit are automatically obtained for later correction of measurement results, the measurement error induced by the test bus of a test access node is reduced.

The solution for automatically checking whether wires are inversed obtains the line A to line B resistance from the test parameters when the access node is short-circuited, and decides whether test line connections are correct according to the line A to line B resistance so as to guarantee correct connection of the wires in a test and enhance the reliability and accuracy of measurements.

Those skilled in the art understand that all or part of the steps in the method according to foregoing embodiments of the invention may be implemented by hardware following instructions of a program. The program may be stored in one or more computer readable storage media, such as a Read-Only Memory/Random Access Memory (RAM/RAM), a magnetic disk and a compact disk. It is apparent that those skilled in the art can make various modifications and variations to the invention without departing from the spirit and scope of the invention. The present invention is intended to cover these modifications and variations provided that they fall in the scope of protection defined by the following claims or their equivalents.

## Claims

1. A method for correcting test bus parameters, comprising:
obtaining test parameters of an access node in an open and/or short circuit; and
correcting measurement results according to the test parameters.

2. The method of claim 1, wherein the step of obtaining the test parameters of the access node in the open circuit comprises:
disconnecting an incoming bus port, an outgoing bus port and an access bus port of the access node and obtaining test result of a test device as the test parameters of the access node in the open circuit.

3. The method of claim 1, wherein the step of obtaining the test parameters of the access node in the short circuit comprises:
disconnecting an outgoing bus port and an access bus port of the access node, looping test lines via an incoming bus port of the access node, and obtaining test result of a test device as the test parameters of the access node in the short circuit.

4. The method of claim 1, wherein:
access nodes are connected via test lines which comprise line A and line B; and
the test parameters comprise one or a combination of line A to ground resistance, line B to ground resistance, line A to line B resistance, line A to ground capacitance, line B to ground capacitance, line A to line B capacitance, line attenuation and line length.

5. A system for correcting test bus parameters, comprising a test device, at least two access nodes, test lines, an obtaining apparatus and a correcting apparatus, wherein:
the test device tests at least one access node bus;
the access nodes are networked in cascade mode via the test lines;
the obtaining apparatus is connected to the correcting apparatus and each access node, and adapted to obtain test parameters of the access node in an open circuit and/or a short circuit; and
the correcting apparatus is connected to the obtaining apparatus and the test device, and adapted to correct measurement results of the test device according to the test parameters obtained by the obtaining apparatus.

6. The system of claim 5, wherein the obtaining apparatus comprises an open circuit obtaining module, and/or a short circuit obtaining module, and a switching module, wherein:
the switching module is connected to the access nodes and adapted to control connection and disconnection of an incoming bus port, an outgoing bus port, and an access bus port of each access node connected with the module;
the open circuit obtaining module is adapted to: control the switching module to break connections of the incoming bus port, outgoing bus port and access bus port of an access node under test, trigger the test device to carry out a test, and obtain test result as test parameters of the access node measured in an open circuit; and
the short circuit obtaining module is adapted to: control the switching module to break connections of the outgoing bus port and access bus port of an access node under test, loop test lines via the incoming bus port, trigger the test device to carry out a test, and obtain test result as test parameters of the access node measured in a short circuit.

7. A method for deciding whether test line connections are correct, comprising:
obtaining line A to line B resistance in test parameters of an access node measured in a short circuit; and
deciding whether test line connections are correct according to the line A to line B resistance.

8. The method of claim 7, wherein the step of obtaining the line A to line B resistance in the test parameters of the access node measured in the short circuit comprises:
disconnecting an outgoing bus port and an access bus port of the access node and looping test lines via an incoming bus port;
obtaining test result of a test device as the test parameters of the access node in the short circuit; and
obtaining the line A to line B resistance from the test parameters.

9. The method of claim 7, further comprising: deciding whether test line connections are correct according to whether the line A to line B resistance is within a self-mixing range.

10. The method of claim 9, wherein the step of deciding whether test line connections are correct according to whether the line A to line B resistance is within the self-mixing range comprises:
deciding that test line connections are correct if the line A to line B resistance is within the self-mixing range; or deciding that test line connections are incorrect if the line A to line B resistance is not within the self-mixing range.

11. The method of claim 9, wherein the self-mixing range means the line A to line B resistance is below 2,000 ohm.

12. A system for deciding whether test line connections are correct, comprising a test device, at least two access nodes, test lines, an obtaining apparatus, an extracting apparatus and a deciding apparatus, wherein:
the test device tests at least one access node bus;
the access nodes are networked in cascade mode via the test lines;
the obtaining apparatus is connected to the extracting apparatus and each access node, and adapted to obtain test parameters of the access node in an open circuit and/or a short circuit;
the extracting apparatus is connected to the deciding apparatus, and adapted to extract line A to line B resistance from the test parameters obtained by the obtaining apparatus; and
the deciding apparatus is adapted to decide whether test line connections are correct according to the line A to line B resistance extracted by the extracting apparatus.

13. The system of claim 12, wherein the obtaining apparatus comprises a short circuit obtaining module and a switching module, wherein:
the switching module is connected to the access nodes and adapted to control connection and disconnection of an incoming bus port, an outgoing bus port, and an access bus port of each access node connected with the module; and
the short circuit obtaining module is adapted to: control the switching module to break connections of the outgoing bus port and access bus port of an access node under test, loop test lines via the incoming bus port, trigger the test device to carry out a test, and obtain test result as test parameters of the access node in a short circuit.

14. The system of claim 12, wherein the deciding apparatus comprises a first deciding module and a second deciding module, wherein:
the first deciding module is adapted to decide that test line connections are correct if the line A to line B resistance is within a self-mixing range; and
the second deciding module is adapted to decide that test line connections are incorrect if the line A to line B resistance is beyond the self-mixing range.
